# EUROPEAN PATENT SPECIFICATION

(11) **EP 4 156 515 B1**
(45) Date of publication and mention of the grant of the patent: **09.12.2026**
(21) Application number: 22196440.6
(22) Date of filing: 20.09.2022
(51) Int. Cl.: H03K 17/94

(54) **THROUGH-DISPLAY INTERFEROMETRIC PROXIMITY AND VELOCITY SENSING**
INTERFEROMETRISCHE NÄHERUNGS- UND GESCHWINDIGKEITSMESSUNG DURCH EINE ANZEIGE
DÉTECTION INTERFÉROMÉTRIQUE DE PROXIMITÉ ET DE VITESSE PAR AFFICHAGE

(30) Priority: 22.09.2021 US 202163247219 P; 06.09.2022 US 202217903840
(43) Date of publication of application: 29.03.2023
(73) Proprietor: Apple Inc., Cupertino, CA 95014 (US)
(72) Inventor: CHEN, Tong, Cupertino, 95014 (US); VAIL, Edward, Cupertino, 95014 (US); WINKLER, Mark T., Cupertino, 95014 (US); GAO, Yongkang, Cupertino, 95014 (US)
(74) Representative: Zacco Denmark A/S

(56) References cited:
- EP-A1- 3 796 140
- WO-A1-2019/015623
- JP-A- 2019 121 691
- US-A- 5 781 297
- US-A1- 2006 182 383
- US-A1- 2008 006 762
- US-A1- 2014 070 078
- US-A1- 2016 054 175
- US-A1- 2017 276 872
- US-B1- 10 222 474
- XIAOFEI DIAO, PENGCHENG HU, ZI XUE, YANHUI KANG: "High-speed high-resolution heterodyneinterferometer using a laser withlow beat frequency", APPLIED OPTICS, vol. 55, no. 1, 22 December 2015 (2015-12-22), pages 110 - 116, XP002808424, Retrieved from the Internet <URL:https://opg.optica.org/view_article.cfm?pdfKey=562b5532-f967-4166-bf8b78b15f9ffa27_333837> [retrieved on 20230112]

## Description

### TECHNICAL FIELD

Embodiments described herein relate to proximity sensing systems for portable electronic devices and, in particular, to interferometric optical sensing systems for object proximity and velocity sensing through an electronic device display.

### BACKGROUND

An electronic device can include a proximity sensor. Typically, a proximity sensor is a reflective infrared sensor that emits a modulated signal in infrared light and monitors for changes in magnitude of reflections of that modulated light to determine whether an object, such as a user, is within at least a threshold distance of the electronic device. In many conventional constructions, a substantial portion of light emitted by the proximity sensor is reflected by portions of the electronic device itself (e.g., cover glass, housing layers, and so on), reducing signal to noise ratio.

Self-reflection and scattering of emitted light may be particularly problematic for a proximity sensor configured to operate through a display of an electronic device. As a result, conventional through-display proximity sensors operating to detect changes in magnitude of reflected light exhibit undesirably poor accuracy and precision when used to detect objects nearby the electronic device, often causing the electronic device to unexpected or undesirable exhibit behavior(s) such as: enabling or disabling a touch screen at unexpected times; dimming or brightening a display at unexpected times; increasing or decreasing speaker volume at unexpected times; and so on. US 2006/182383 A1, US 5 781 297 A, and "High-speed high-resolution heterodyne interferometer using a laser with low beat frequency", Applied Optics, vol. 55, no. 1, Xiaofei Diao et al., relate to systems for optical distance measurement.

### SUMMARY

Embodiments described herein take the form of an electronic device including an optical sensing system for detecting proximity of and velocity of an object external to the electronic device according to claim 1 . The optical sensing system includes a light emitter, which may be an infrared laser or set of infrared lasers. The light emitter is configured to emit light toward the object to illuminate the object. In many implementations, the optical sensing system is configured to be disposed below a display of the electronic device. In such constructions, the light emitter is configured to emit light, and to illuminate the object, through the display. The optical sensing system also includes a photosensitive element, such as a photodiode. The photodiode can be configured to receive light reflecting from the object, which may in many constructions also pass through the display.

The optical sensing system further includes an optical waveguide coupling the light emitter and the photosensitive element. As a result of this construction, the optical sensing system can be operated as an interferometric optical sensor or, more specifically, as a heterodyne interferometer. Output from the optical sensing system can be analyzed in frequency and/or time domain to determine a velocity of the object relative to the electronic device and a distance separating the object and the electronic device, which in tum may be used by the electronic device to perform a function, such as disabling or enabling the display.

### BRIEF DESCRIPTION OF THE DRAWINGS

Reference will now be made to representative embodiments illustrated in the accompanying figures. It should be understood that the following descriptions are not intended to limit this disclosure to one included embodiment.
FIG. 1 depicts an electronic device incorporating an optical sensing system to detect proximity and velocity of an object, such as described herein.
FIG. 2 depicts a simplified system diagram of an optical sensing system as described herein.
FIG. 3 depicts a simplified system diagram of an optical sensing system including a waveguide coupling transmit and receive sides, as described herein.
FIG. 4A depicts a system diagram of an optical sensing system implemented with a photonic integrated circuit, such as described herein.
FIG. 4B depicts a schematic diagram of an optical sensing system implemented with a photonic integrated circuit, such as described herein.
FIG. 5 depicts a system diagram of an optical sensing system, such as described herein.
FIG. 6 is a chart depicting velocity plotted against distance of an object nearby an electronic device.
FIG. 7 is a flowchart depicting example operations of another method of operating an optical sensing system, such as described herein.
FIG. 8 is a flowchart depicting example operations of another method of operating an optical sensing system, such as described herein.

The use of the same or similar reference numerals in different figures indicates similar, related, or identical items.

Certain accompanying figures include vectors, rays, traces and/or other visual representations of one or more example paths - which may include reflections, refractions, diffractions, and so on, through one or more mediums - that may be taken by, or may be presented to represent, one or more photons, wavelets, or other propagating electromagnetic energy originating from, or generated by, one or more light sources shown or, or in some cases, omitted from, the accompanying figures. It is understood that these simplified visual representations of light or, more generally, electromagnetic energy, regardless of spectrum (e.g., ultraviolet, visible light, infrared, and so on), are provided merely to facilitate an understanding of the various embodiments described herein and, accordingly, may not necessarily be presented or illustrated to scale or with angular precision or accuracy, and, as such, are not intended to indicate any preference or requirement for an illustrated embodiment to receive, emit, reflect, refract, focus, and/or diffract light at any particular illustrated angle, orientation, polarization, color, or direction, to the exclusion of other embodiments described or referenced herein.

Additionally, it should be understood that the proportions and dimensions (either relative or absolute) of the various features and elements (and collections and groupings thereof) and the boundaries, separations, and positional relationships presented therebetween, are provided in the accompanying figures merely to facilitate an understanding of the various embodiments described herein and, accordingly, may not necessarily be presented or illustrated to scale, and are not intended to indicate any preference or requirement for an illustrated embodiment to the exclusion of embodiments described with reference thereto.

### DETAILED DESCRIPTION

Embodiments described herein reference an optical sensing system disposed below/behind a display, and configured to operate through the display (e.g., through inter-pixel regions of the display) of an electronic device. More specifically, the optical sensing system can be configured to illuminate a scene within a field of view of the sensing system through the display, and can be configured to receive light reflected from one or more objects in the scene and within the field of view of the sensing system. Some light reflected from a surface or subsurface of an object within the scene traverses through the display again, and can be received and analyzed and/or filtered by the optical sensing system.

In one configuration, an optical sensing system as described herein is leveraged as a user proximity sensor of a portable electronic device having a capacitive touch screen, such as a cellular phone. Output from the user proximity sensor can be used by the portable electronic device to disable the capacitive touch screen when the user positions the portable electronic device nearby the user's head and to reenable the capacitive touch screen when the user withdraws the portable electronic device from the user's head. In a more simple phrasing, an optical sensing system operable as a user proximity sensor, as described herein, can be used to prevent unintended input to a capacitive touch screen and/or to save device power by disabling a display when a user places or stores the portable electronic device in a pocket or bag.

An optical sensing system as described herein includes a transmit side (TX) and a receive side (RX). In contrast to conventional optical sensing systems that operate by detecting changes in light intensity (which may be referred to as changes in brightness or power), a system as described herein is configured to operate as a coherent optical system, leveraging photon mixing at the receive side to form a heterodyne interferometer. The heterodyne interferometer compares two paths, a scene illumination path (including a round-trip through the display, reflecting from an object proximate to the system) and a reference path defined by optically coupling, via a waveguide, the transmit side and the receive side. As a result of this construction the optical sensing system is responsive to, and leverages, principles of optical field strength fading and is not, as with conventional optical sensing systems, reliant on changes in light intensity.

As known to a person of skill in the art, intensity of light from a source or an object from which light is reflected is inversely proportional to the square of the distance from that source or object. In other words, conventional optical sensing systems that rely on measuring light intensity or brightness (e.g., optical power) are configured to measure a signal that falls off with the square of distance. As a result, conventional through-display optical sensing systems are highly sensitive to noise, backscattering, TX/RX cross-talk, and other interference sources - especially as distance to an object increases.

Further, issues with conventional methods of operating a conventional through-display optical sensing system may be particularly problematic if operating through a display or other low-transparency, highly reflective, and/or highly absorptive layer or set of layers (as one example, a "display stack" at least in part defining an electronic display for an electronic device). For example, a display, especially a high-resolution display, configured for through-display imaging may only exhibit 5% transmissivity. In other words, the display stack otherwise reflects, diffracts, and/or absorbs 95% of power output from a conventional optical sensing system operated therewith.

In this construction, light received by a receive side of the conventional optical sensing system must necessarily, once again, pass through the same display stack, which once again permits only 5% of incident light to traverse therethrough. In this simplified example, only, at best, 0.25% of power output from the conventional optical sensing system can be analyzed to obtain a useful signal corresponding to an object's proximity to the conventional optical sensing system. As known to a person of skill in the art, this 0.25% of useful power is subject to falloff/attenuation with the square of distance to any object with in the field of view of the conventional optical sensing system. As a result, the conventional system typically is required to illuminate a scene for at least a threshold period of time (e.g., 200ms, 500ms, and similar scale) such that usable signal can be received by the received side.

In view of the foregoing example, it may be appreciated that, a conventional through-display optical sensing system reliant on changes in received light intensity to determine an object's proximity to an electronic device exhibits, at best, poor performance and wastes substantially all power output to recover only minimal usable signal. As such, conventional through-display optical sensing systems may not be suitable for use with many electronic devices, especially low-power electronic devices such as wearable electronic devices or small form-factor electronic devices.

By contrast, systems described herein leverage optical field strength fading which does not fall off with the square of distance to an object or optical source. In other words, by leveraging a field-based approach, a system as described herein can exhibit substantial signal to noise ratio gains over conventional intensity-based (power-based) systems. In some cases, a field-based approach exhibits 35db or greater SNR gain over conventional systems.

In addition, with increased signal-to-noise ratio, a system described herein can be operated for substantially shorter time periods, thereby saving substantial power. Further, with increased signal quality, more detailed and in-depth analysis of a signal can be performed to further tune, filter, or otherwise interpret signal(s) obtained from/by the system.

More specifically, embodiments described herein reference an optical sensing system including a transmitter side and a receiver side. The transmitter side includes at least one light-emitting element configured to emit light through a display of an electronic device, such as an organic light-emitting diode display. More specifically, the transmitter side includes at least one light-emitting element configured and positioned to emit infrared laser light through inter-pixel regions of an active display area of a display of an electronic device, such as a cellular phone or wearable electronic device.

The light emitted by the transmitter side of the optical sensing system as described herein may illuminate object(s) in free space proximate to the electronic device, within a field of view of the optical sensing system. An example object, as noted above may be a user or operator of the electronic device. Reflections from these object(s) may, in part, return to the optical sensing system, once again traversing the display (and inter-pixel regions of the display) to be received by the receiver side.

In many cases, the light-emitting element includes a laser, typically implemented as a vertical cavity surface emitting laser (VCSEL), although this is merely one example and other lasing elements may be used. For simplicity of description, the embodiments that follow reference an optical sensing system including at least one VCSEL light source (hereinafter, a "laser" or "laser diode") that emits light in a spectral range including a traditionally non-visible frequency band (e.g., infrared light). Further, although not required for all embodiments, the example VCSEL light source described in reference to many embodiments that follow is presumed to be a Class 1 laser as defined by the American National Standards Association.

The receiver side of an optical sensing system as described herein includes at least one photosensitive element, which may be a photodiode responsive to interactions with photons having a frequency within band of light emitted by the light-emitting element. In a more simple phrasing, if the light-emitting element is configured to emit blue light at 450nm wavelength, the photodiode of the receive side may be selected and/or constructed to generate (or modify) an electrical signal when illuminated by photons having 450nm wavelength. This is merely one example; in many implementations the light-emitting element, and correspondingly the photodiode, may be configured to operate in an infrared band of light not typically visible to a human user of the electronic device.

For simplicity of description, the embodiments that follow reference an optical sensing system with a receive side photosensitive element including at least one semiconductor photodiode (hereinafter, simply, a "photodiode"). The photodiode can be manufactured with photosensitive area and may be operated in a photoconductive mode. As noted above, the photosensitive area of an example photodiode described herein may be responsive to light in the spectral range emitted by a laser diode of the optical sensing system.

In addition to the foregoing described construction, the transmitter side and the receiver side of an optical sensing system as described herein may be optically coupled via a waveguide internal to the optical sensing system such that light emitted by the light-emitting element of the transmitter side is received by the photo diode of the receiver side. As a result of this construction, light that passes through the display, having reflected from an object nearby or proximate to the electronic device, can be mixed with light passing through the waveguide, inducing constructive or destructive interference (in other words, forming a heterodyne interferometer) that in tum may be used to determine a distance to, and/or a velocity of, the object.

In many examples, the optical sensing system can include multiple photosensitive elements and/or multiple photosensitive areas associated with one or more photosensitive elements. In such cases, photodiodes can be operated in a balanced configuration or may be separately sampled. In some cases, an array of photodiodes may be used to generate, at least in part, a multidimensional map or image of an object in proximity of the electronic device.

As noted above and with respect to other embodiments described herein, an optical sensing system can include a processor and a memory, which may be formed or defined as a portion of an application-specific integrated circuit. The memory can store instructions that, when accessed by the processor cause the processor to instantiate an instance of control software or firmware.

The firmware can cause the application-specific integrated circuit (ASIC) to perform one or more analysis operations against and/or with output(s) received from one or more photosensitive elements of the optical sensing system. For example, the ASIC may be configured to perform a time domain and/or a frequency domain analysis to determine one or more properties or characteristics of output(s) received from the one or more photosensitive elements. As one example, the ASIC may be configured to identify a central frequency, a beat frequency, an intermediate frequency, a phase (or phase shift), a time delay, and so on. Any of these data may be leveraged to inform a determination of distance to and/or velocity of an object nearby an electronic device incorporating the optical sensing system.

More broadly, in many embodiments and as note above, the optical sensing system can be configured for use as a proximity sensor for a mobile or portable electronic device, but this is merely one example.

It may be appreciated that any suitable optical sensing or imaging system can utilize the techniques and architectures described herein to receive and/or emit light. Examples include, but are not limited to: light meters; light color sensors; proximity sensors; dot projectors; rangefinders; infrared image capture systems; ultraviolet image capture systems; direct time-of-flight depth sensors; indirect time-of-flight depth sensors; and so on.

For example, some embodiments reference an electronic device that includes a display, such as a micro-scale light-emitting diode display ("microLED") or an organic light-emitting diode display ("OLED"). These example electronic devices can further include an optical sensing system as described herein configured to operate as a reflective optical sensor that illuminates a field of view and monitors for reflections of emitted light within that field of view to infer that an optically reflective object, such as a user of the electronic device, is present within the field of view.

As noted above, an optical sensing system is configured to operate in the infrared wavelength band and is positioned on or coupled to a rear surface of, and/or integrated within, an active display area of the display of the electronic device. More specifically, as used herein the phrase "rear surface" of an active display area of a display refers to a surface of a display opposite a surface from which light is emitted by that display, which is referred to herein as the "front surface" of the display.

In this manner, and as a result of this construction, an optical sensing system can illuminate objects that are nearby the display, such as a user. As may be appreciated by a person of skill in the art, objects proximate to the display reflect some of the light emitted by the optical sensing system. A portion of the object-reflected light is directed back toward the display and can be captured by the optical sensing system, positioned behind the display. The received light can be mixed with light directly received from the transmit side (traversing a waveguide) to form a heterodyne interferometer. Output from the interferometer may be differential or cumulative. In many examples, a differential output of the interferometer may be quantified and/or digitized and thereafter consumed by the electronic device (or other circuitry, such as analysis circuitry or functions of an ASIC) to perform or inform some task.

More generally, the electronic device can utilize information received from the optical sensing system to perform any suitable task or operation or sets thereof. Examples include, but are not limited to: disabling or reducing a brightness of a display of the electronic device in response to receiving information from the optical sensing system that an object is closer than a threshold distance to the electronic device; enabling or increasing a brightness of a display of the electronic device in response to receiving information from the optical sensing system that an object is farther than a threshold distance to the electronic device; enabling or disabling a touch or force input system of the electronic device in response to receiving information from the optical sensing system that an object is nearby (e.g., a distance satisfying a threshold or within a threshold range) the electronic device; and so on.

In this manner, more generally and broadly, embodiments described herein can be used to facilitate through-display detection (and/or imaging) of an object and its velocity nearby the front surface of a display of an electronic device.

By using both velocity and distance measurements (e.g., as a pair), for example, the electronic device can more effectively determine whether a user is intentionally lifting the electronic device to the user's head and/or intentionally withdrawing the electronic device from the user's head. In other cases, distance and velocity may be used to receive direct user input. For example, a user may wave a hand above the electronic device display to dismiss or display a notification. These examples are not exhaustive; a person of skill in the art may readily appreciate that output from an optical sensing system as described herein may be used to perform, coordinate, and/or execute any suitable electronic device function or operation.

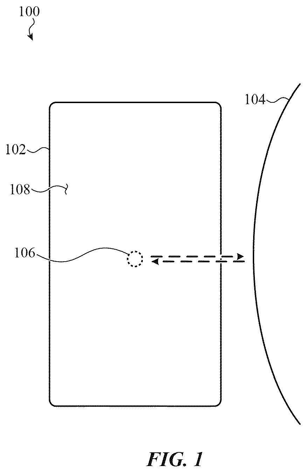

These foregoing and other embodiments are discussed below with reference to FIGs. 1 - 7. However, those skilled in the art will readily appreciate that the detailed description given herein with respect to these figures is for explanation only and should not be construed as limiting.

FIG. 1 depicts an electronic device 100, including a housing 102 that encloses a stack of multiple layers, referred to as a "display stack", that cooperates to define a digital display configured to render visual content to convey information to, to solicit touch or force input from, and/or to provide entertainment to a user 104 of the electronic device 100. Behind the display stack, and within the housing, can be disposed an optical sensing system 106 configured, as with other embodiments described herein, to illuminate the user 104 and to receive reflections from that illumination in order to determine a velocity of the user 104 and/or a distance separating the user 104 from the electronic device 100.

The display stack can include layers or elements such as, in no particular order: a touch input layer; a force input layer; a haptic output layer; a thin-film transistor layer; an anode layer; a cathode layer; an organic layer; an encapsulation layer; a reflector layer; a stiffening layer; an injection layer; a transport layer; a polarizer layer; an anti-reflective layer; a liquid crystal layer; a backlight layer; one or more adhesive layers; a compressible layer; an ink layer; a mask layer; and so on.

For simplicity of description, the embodiments that follow reference a display stack including an organic light-emitting diode display technology and can include, among other layers: a reflective backing layer; a thin-film transistor layer; an encapsulation layer; and an emitting layer. It is appreciated, however, that this is merely one illustrative example implementation and that other displays and display stacks can be implemented with other display technologies, or combinations thereof. An example of another display technology that can be used with display stacks and/or displays such as described herein is a micro light-emitting diode display.

The display stack also typically includes an input sensor (such as a force input sensor and/or a touch input sensor) to detect one or more characteristics of a user's physical interaction with an active display area 108 defined by the display stack of the display of the electronic device 100.

The active display area 108 is typically characterized by an arrangement of individually-controllable, physically-separated, and addressable pixels or subpixels distributed at one or more pixel densities and in one or more pixel or subpixel distribution patterns. In a more general phrasing, the active display area 108 is typically characterized by an arrangement of individually-addressable discrete light-emitting regions or areas that are physically separated from adjacent or other nearby light-emitting regions.

In many embodiments, the light-emitting regions defining the active display area 108 are disposed onto, or formed onto, a transparent substrate that may be flexible or rigid. Example materials that can form a transparent substrate, such as described herein can include polyethylene terephthalate and/or glass. In other cases, a partially opaque substrate can be used; in such embodiments, at least a portion of the substrate between the pixels defined thereon may be partially or entirely optically transparent.

In addition, example input characteristics that can be detected by an input sensor of the electronic device 100 - which can be disposed above or below a display stack, or, in other cases, can be integrated with a display stack - can include, but are not limited to: touch location; force input location; touch gesture path, length, duration, and/or shape; force gesture path, length, duration, and/or shape; magnitude of force input; number of simultaneous force inputs; number of simultaneous touch inputs; and so on.

As a result of these constructions, the user 104 of the electronic device 100 may be encouraged to interact with content shown in the active display area 108 of the display by physically touching and/or applying a force with the user's finger to the input surface above an arbitrary or specific region of the active display area 108.

In these embodiments, as with other embodiments described herein, the display stack is additionally configured to facilitate through-display proximity sensing. In particular, the display stack further includes and/or is coupled to the optical sensing system 106, which is positioned within the housing relative to and/or interfacing with a rear surface of the display stack. As a result of this construction, the optical sensing system 106 can be operated by the electronic device 100 to determine whether an object, such as the user 104, is proximate to the active display area 108 of the electronic device 100.

More specifically, in one example, the display stack defines an optical sensing aperture or an array of discrete and separated optical sensing apertures (not shown) through a backing layer or other opaque layer defining a rear surface of the display stack, thereby permitting light to travel through the display stack from the front surface to the rear surface (and vice versa) between two or more organic light-emitting diode subpixels or pixels (herein, "inter-pixel" regions).

In some cases, the optical sensing aperture takes a rectangular shape and is define on a central region of the active display area 108, but this may not be required.

In other cases, the optical sensing aperture takes a circular or oval shape and is disposed in another region of the active display area 108. In some embodiments, the backing layer may be omitted entirely; the optical sensing aperture may take the same size and shape as the active display area 108.

In some embodiments, multiple optical sensing apertures with different shapes are separated and supported by opaque and light absorbing backing layer or additional optical/mechanical structure. Each of these apertures may be associated with a respective separate optical sensing system and/or may be associated with different TX or RX portions of the optical sensing system 106.

In these embodiments, the optical sensing system 106 can be positioned at least partially below the optical sensing aperture in order to collect and quantify light directed through the inter-pixel regions of the display stack, traveling through the display stack in a direction substantially opposite to a direction of travel of light emitted by the display stack. In many cases, operation of the optical sensing system 106 may be synchronized with operation of the display such that display pixels above the optical sensing system 106 are off when the optical sensing system is operating to illuminate the user 104. In a more broad phrasing, the display may be configured to operate at a particular refresh rate or duty cycle; during off periods of the duty cycle of particular pixels, the optical sensing system 106 may operate. This synchronized operation between the active display area 104 and the optical sensing system 106 may not be required of all embodiments.

More generally, as noted above, the optical sensing system 106 is configured to emit and capture light incident to the front surface of the display that passes through an inter-pixel region of the display stack.

In some embodiments, the optical sensing system 106 can be configured to operate with the display such that the display emits light in order to illuminate an object in contact with the front surface of the display (or an outer protective layer covering the front surface of the display). In these examples, light emitted from one or more light-emitting regions of the display (e.g., pixels) can be reflected from the surface of the object and, thereafter, can travel through the display stack, through an optical sensing aperture, and can be collected/absorbed by at least one photosensitive area or region (e.g., a photodiode) of the optical sensing system 106.

In particular, as noted with respect to other embodiments described herein, the optical sensing system 106 may be configured to emit light through the optical sensing aperture and to receive light from the optical sensing aperture. The light 108 emitted and received by the optical sensing system 106 may be used to detect the presence, velocity, and/or proximity and/or range of an object, such as the user 104.

These foregoing embodiments depicted in FIG. 1 and the various alternatives thereof and variations thereto are presented, generally, for purposes of explanation, and to facilitate an understanding of various configurations and constructions of a system, such as described herein. However, it will be apparent to one skilled in the art that some of the specific details presented herein may not be required in order to practice a particular described embodiment, or an equivalent thereof.

Thus, it is understood that the foregoing and following descriptions of specific embodiments are presented for the limited purposes of illustration and description. These descriptions are not targeted to be exhaustive or to limit the disclosure to the precise forms recited herein. To the contrary, it will be apparent to one of ordinary skill in the art that many modifications and variations are possible in view of the above teachings.

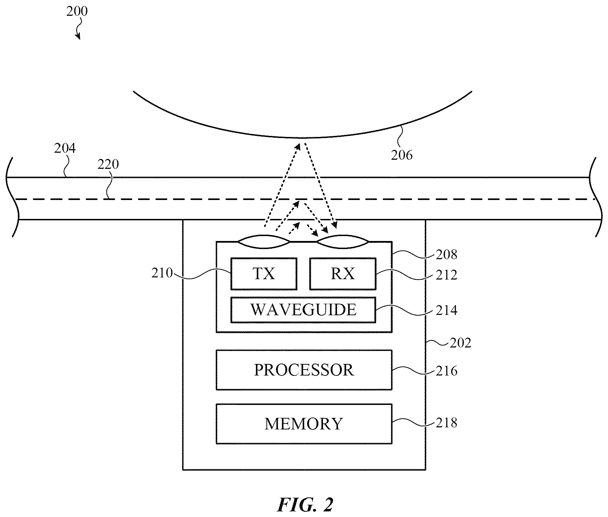

Generally and broadly, FIGs. 2 - 3 depict example cross-sectional views of an optical sensing system, such as described herein. In particular, Fig. 2 depicts a cross-section view through line A-A of FIG. 1. In these examples, an optical sensing system includes a transmitter side (also referred to as a "transmitter module") and a receiver side (also referred to as a "receiver module") to define a reflective sensor. As with other embodiments described herein, the transmitter side includes a light-emitting element disposed within a barrel referred to herein as a transmitter barrel and the receiver side includes a photosensitive element disposed within a second barrel, referred to herein as a receiver barrel.

As a result of the separate barrels separately enclosing the transmitter side and receiver side, the transmitter side may be substantially optically isolated from the receiver side such that light emitted by the transmitter side and directed toward a display does not substantially interfere with light received by the receiver side. Despite this construction, however, as noted above, the transmitter side and the receiver side can be directly optically coupled via a waveguide. In this manner, the waveguide may convey reference light to the receive side such that light received through the display (a scene "illumination path") may be mixed with reference light (sent via the waveguide, a "reference path") to for an heterodyne interferometric sensor. Differential and/or cumulative output from the heterodyne interferometer can be thereafter analyzed to determine, as one example, a beat frequency or central frequency or phase shift between the scene illumination path and the reference path.

More broadly, as a result of this construction, when the light-emitting element receives a current and emits light, that light exits the transmitter-side barrel and enters the waveguide, illuminating a field of view of the light-emitting element and propagating light into the waveguide.

If an object, such as a user, enters the field of view of the light-emitting element, at least a portion of the light emitted by the light-emitting element will be reflected back toward the optical sensing system. A portion of that reflected light can enter the receiver-side barrel and may be mixed with light from the reference path. The combined received light may illuminate the photosensitive element which, in turn, can generate a current or voltage in proportion to one or more properties of the combined received light. Discrete domain, frequency domain, and/or time domain analysis can be performed against a analog and/or digital representations of signals output from the photosensitive element.

For example, FIG. 2 illustrates an electronic device 200 that includes a housing that defines an interior volume to enclose and support an optical sensing system 202 positioned on a back surface of a display 204.

The optical sensing system 202 can be used to detect proximity and/or velocity of an object 206, which can be a user of the electronic device 200. For example, if the electronic device 200 is a portable electronic device such as a cellular phone, the optical sensing system 202 can be leveraged as a proximity sensor that determines when and/or whether the cellular phone should disable a capacitive touch screen (e.g., when a user of the cellular phone holds the cellular phone nearby the user's head/ear).

As with other embodiments described herein, the optical sensing system 202 can be configured to emit light through the display 204. The light exits the housing of the electronic device 200 to illuminate a field of view normal to and/or extending from an external surface of the display 204.

When the object 206 enters the field of view, at least a portion of the light is reflected from an external surface of the object 206. The reflected light is redirected toward the outer surface of the display 204. At least a portion of the reflected light can traverse through the display 204 and can illuminate a receive side of the optical sensing system 202. The optical sensing system 202 can leverage this illumination to determine whether the object 206 is proximate to, or within at least a threshold distance of, the external surface of the electronic device 200.

The optical sensing system 202 is enclosed within a module housing 208 that encloses and supports at least a portion of the internal components thereof. As with other embodiments described herein, the module housing 208 defines a transmitter side 210 and a receiver side 212 that may be optically coupled by a waveguide 214. In particular, the module housing 208 defines a set of barrels that includes a transmitter barrel and a receiver barrel that are optically isolated from one another to minimize crosstalk therebetween.

The module housing 208 also encloses and supports an ASIC that includes at least a processor 216 and a memory 218. In other cases, the processor 216 and the memory 218 can be formed on separate dies and/or within separate integrated circuit packages. The processor 216 can be a general purpose processor configured to access the memory 218 to obtain executable instructions, computer code, and/or other digital assets that can be leveraged by the processor 216 to instantiate an application, firmware, or other process or instance of software.

In other cases, the processor 216 may be a purpose-configured processor configured to receive digital input(s) and to provide digital and/or analog output(s). As such, as described herein, the term "processor" refers to any software and/or hardware-implemented data processing device or circuit physically and/or structurally configured to instantiate one or more classes or objects that are purpose-configured to perform specific transformations of data including operations represented as code and/or instructions included in a program that can be stored within, and accessed from, a memory (such as the memory 218). This term is meant to encompass a single processor or processing unit, multiple processors, multiple processing units, analog or digital circuits, or other suitably configured computing element or combination of elements.

Regardless of configuration, the processor 216 can be operationally and/or communicably coupled to the memory 218 and/or to other electronic components of the electronic device 200 or the optical sensing system 202.

For example, the processor 216 can be operably coupled to a transmitter controller and a receiver controller. As a result of these constructions, the processor 216 can be leveraged to perform one or more field calibration operations with the transmitter controller or the receiver controller, such as described herein. Such calibrations can include, but may not be limited to: thermal calibration of a light-emitting element of the transmitter controller; thermal calibration of a photosensitive element or photosensor of the receiver controller; optical output calibration/adjustment of the transmitter controller; and so on.

The memory 218 of the ASIC can be used, as noted above, to store assets that can be leveraged by the processor 216. In other cases, the memory 218 can be used to store one or more lookup tables that can be used to calibrate (e.g., a field calibration) in real time or in response to an instruction form the electronic device 200 the optical sensing system 202, such as described herein. In certain further embodiments, the optical sensing system 202 can further include one or more optical elements, such as a transmitter-side collimator and a receiver-side concentrator.

As a result of the depicted construction, the optical sensing system 202 can be calibrated in real time by the processor 216 such that the light emitted by the transmitter controller can pass through the display 204 (and, in particular, between inter-pixel regions of a pixel layer 220 of the display 204), reflect from the object 206, pass through the display 204 and the pixel layer 220 again, and enter the receiver side at which point that light may be mixed with light traversing the waveguide 214.

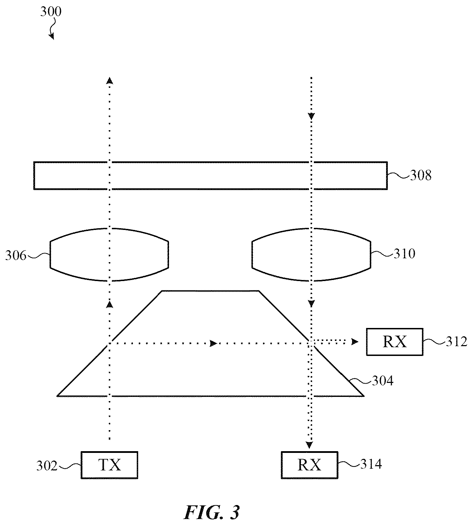

FIG. 3 depicts a simplified cross-section view of an optical sensing system, such as described herein. The optical sensing system 300 includes a light-emitting element 302 configured to emit laser light into a beam splitter/waveguide 304. The beam splitter/waveguide 304 may divide port output from the light-emitting element 302 along two paths, one referred to as a scene illumination path and one referred to a reference path. Light traversing the scene illumination path optionally passes through a collimator 306 (or other optical element or set of optical elements) before passing through a scattering media 308, which may be a display stack of a display of an electronic device. Light traversing the reference path is redirected through the beam splitter/waveguide 304.

Light passing along the scene illumination path may reflect from a surface or subsurface of an object within a field of view of the optical sensing system 300, such as the skin of a user of an electronic device.

Light that reflects from the object can once again pass through the scattering media 308, optionally through a concentrator 310, and may re-enter the beam splitter/waveguide 304 at which point this light mixes with light following the reference path. In this manner, as may be appreciated, the beam splitter/waveguide 304 serves to recombine coherent light contained within the light reflected from the object and, thus, functions as a heterodyne interferometer. Once combined, the light can be received at a photosensitive element 312 and/or a photosensitive element 314.

The light-emitting element 302 can be any suitable light-emitting element, but in many embodiments, the light-emitting element 302 is implemented as a VCSEL and configured to emit infrared light. In other embodiments, the light-emitting element 302 is a semiconductor light source such as, but not limited to: a vertical external-cavity surface-emitting laser; a light-emitting diode; an organic light-emitting diode; a resonant-cavity light-emitting diode; a micro-scale light-emitting diode; a superluminescent light-emitting diode; a broad-area laser diode; a diode-pumped laser; a mode-locked diode laser; an infrared band laser; an ultraviolet band laser; and so on. The light-emitting element 302 can be implemented as a single element or as an array of discrete elements.

The photosensitive element 312 and/or a photosensitive element 314 can be any suitable photosensitive element or structure. For simplicity of description, the embodiments that follow reference a semiconductor photodiode (hereinafter, a "photodiode"). The photosensitive area of this example photodiode is responsive to light in the spectral range emitted by the light-emitting element 302. As with the light-emitting element 302, the photosensitive element 312 and/or a photosensitive element 314 of the receiver side can be implemented as a single element or as an array of elements.

Both the photosensitive element 312 and/or a photosensitive element 314 and the light-emitting element 302 are operably or physically coupled to an ASIC. The ASIC can be configured to drive the light-emitting element 302 with a current, a modulated current, or any other suitable current-controlled, power-controlled, or voltage-controlled signal. In many examples, the ASIC is configured to drive the light-emitting element 302 with a current signal configured to cause the light-emitting element 302 to emit modulated infrared light into the field of view of the optical sensing system 300. In addition, the ASIC can be configured to receive a current, voltage, or power signal from the photosensitive element 312 and/or a photosensitive element 314.

These foregoing embodiments depicted in FIGs. 2 - 3 and the various alternatives thereof and variations thereto are presented, generally, for purposes of explanation, and to facilitate an understanding of various configurations and constructions of a system, such as described herein. However, it will be apparent to one skilled in the art that some of the specific details presented herein may not be required in order to practice a particular described embodiment, or an equivalent thereof.

Thus, it is understood that the foregoing and following descriptions of specific embodiments are presented for the limited purposes of illustration and description. These descriptions are not targeted to be exhaustive or to limit the disclosure to the precise forms recited herein. To the contrary, it will be apparent to one of ordinary skill in the art that many modifications and variations are possible in view of the above teachings.

For example, a dedicated waveguide may not be required of all embodiments; in some cases, light that traverses through one or more layers of a display stack can define a reference path. In other cases, multiple reference paths may be defined, via multiple waveguides and/or multiple paths through a display stack.

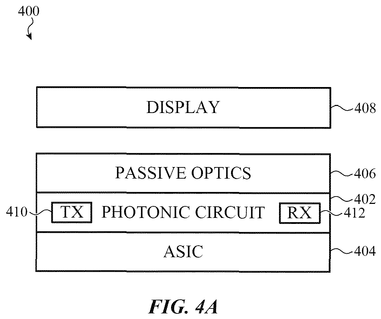

In other cases, the optical sensing system can be implemented at least in part as a photonic circuit. For example, FIG. 4A depicts a simplified system diagram of an integrated photonic circuit defining an optical sensing system as described herein. The optical sensing system 400 includes a photonic integrated circuit 402 that is formed over a silicon semiconductor circuitry 404 defining an application-specific integrated circuit configured to perform or coordinate one or more operations of the optical sensing system 400.

The photonic integrated circuit 402 can include one or more waveguides (e.g., a silicon waveguide or silicon nitride waveguide) configured to optically couple light emitting from a transmit side to a receive side of the optical sensing system 400. The photonic integrated circuit 402 can be positioned below and/or may have formed thereon, one or more passive optical structures, such as lenses, collimators, or other filters. Passive optical structures, identified in the figure as the passive optical structures 406 may include one or more active lens structures or optical elements, such as an electrochromic shutter or liquid crystal shutter or other electrically-controllable lens or optical element.

This stack defining the optical sensing system 400 can be positioned below a scattering media, such as a display 408. As a result of this construction, light emitted from the transmit side via a light-emitting element 410 can be received at a photosensitive element 412 after light sent along a scene illumination path is recombined with light sent along a reference path through one or more waveguides define in the photonic integrated circuit 402.

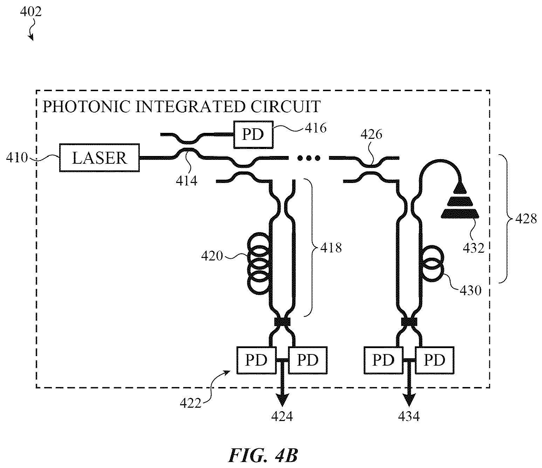

FIG. 4B depicts the photonic integrated circuit 402 in greater schematic detail. In this example, the light-emitting element 410 can be optically coupled to a directional coupler 414. The directional coupler 414 can be used, in some examples, to provide optical input to a reference photodiode 416 that in turn may be used to monitor output from the light-emitting element 410. For example, output from the reference photodiode 416 may be used to inform a current driving the light-emitting element 410 for example to maintain a particular or consistent wavelength of light output from the light-emitting element 410. In some examples, the reference photodiode may be integrated into the light-emitting element 410 and/or may be omitted entirely.

The directional coupler 414 can also provide output to one or more reference paths that optically couple to one or more receive-side photodiodes (or balanced photodiode pairs). For example, in one embodiment, the directional coupler 414 provides output to a first waveguide 418 that includes a delay loop 420. The length of the delay loop 420 may vary from embodiment to embodiment, and may be informed by, in one example, a thickness of the display stack.

Output from the first waveguide 418 may be provided as input to a balanced photodiode pair 422 (which may define a single photosensitive element) that can be positioned to also receive light that followed a scene illumination path as described above. The balanced photodiode pair 422 can provide a combined output 424.

In some embodiments more than one receive side photosensitive element can be used. In these cases, the optical sensing system 400 and the photonic integrated circuit 402 can include and/or define multiple reference paths. For example, output from the directional coupler 414 can be provided as input to a power-dividing tree of directional couplers, each branch of the tree coupling to a unique and/or discrete reference path.

For simplicity of illustration, only a single additional directional coupler is shown, identified as the directional coupler 426. The directional coupler 426 provides input to another waveguide identified as the second waveguide 428.

The second waveguide 428 can be configured with two branches, one of which includes a delay line 430 that feeds into a Bragg reflector 432. The delay line 430 may have half as much delay as the delay loop 420, but this may not be required of all embodiments. As a result of this construction, the second waveguide 428 can be configured for particular frequency responsiveness. Other waveguides (not shown) can be configured for responsiveness to other frequencies of light.

Output from the second waveguide 428, which may also be provided as input to a photosensitive element defined by a pair of photodiodes, can provide an output 434.

These foregoing embodiments depicted in FIGs. 4A - 4B and the various alternatives thereof and variations thereto are presented, generally, for purposes of explanation, and to facilitate an understanding of various configurations and constructions of a system, such as described herein, implemented in part in a photonic integrated circuit. However, it will be apparent to one skilled in the art that some of the specific details presented herein may not be required in order to practice a particular described embodiment, or an equivalent thereof.

Thus, it is understood that the foregoing and following descriptions of specific embodiments are presented for the limited purposes of illustration and description. These descriptions are not targeted to be exhaustive or to limit the disclosure to the precise forms recited herein. To the contrary, it will be apparent to one of ordinary skill in the art that many modifications and variations are possible in view of the above teachings.

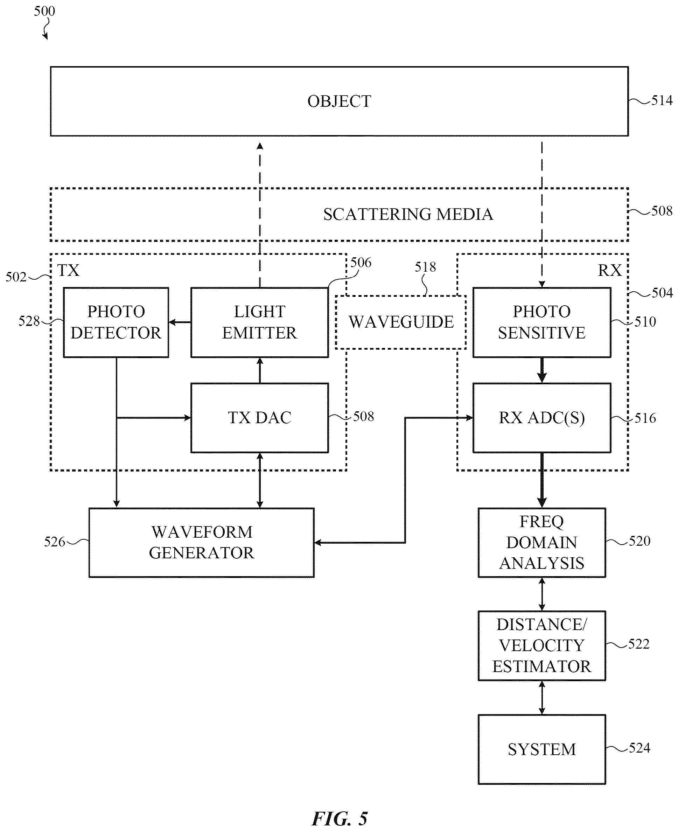

For example, FIG. 5 depicts a simplified system diagram of an optical sensing system, such as described herein. The optical sensing system 500 is configured to detect presence of and/or velocity and/or distance to an object 502, through a scattering media such as a display of an electronic device. In other examples, other scattering media may be present.

The optical sensing system 500 includes a transmitter side 502 and a receiver side 504. The transmitter side 502 includes a light-emitting element, shown as the light emitter 506. The light emitter 506 receives an analog power or current signal from a digital-to-analog converter 508.

In this manner, a digital current value received by the digital-to-analog converter 508 is converted to an analog current which, in turn, causes the light emitter 506 to emit light, such as modulated infrared light.

Similarly, the optical sensing system 500 includes the receiver side 504 that includes a photosensitive element 510. The photosensitive element 510 is configured to receive light emitted from the light emitter 506. Some of the light emitted by the light emitter 506 may traverse scattering media, such as the scattering media 512 and thereafter reflect from an object, such as the object 514. A current, voltage, and/or power signal output from the photosensitive element 510 can be received as input by an analog-to-digital converter 516 of the receiver side 504.

In addition, the photosensitive element 510 may be configured to receive light from the light emitter 506 that traversed a reference path that passed through a waveguide 518, such as described above.

In this manner, and as a result of this construction, the photosensitive element 510 receives light that reflected from the object 514 and light from the light emitter 506 (via the waveguide 518), mixing the two to provide a single interferometric output to the analog-to-digital converter 516.

As noted above, output from the analog-to-digital converter 516 can be analyzed in frequency, discreet, or time domains to estimate a distance and/or velocity associated with the object 514. For example, an output of the analog-to-digital converter 516 can be provided as input to a frequency domain analysis block 520 that, in turn can provide output to a distance and velocity estimator 522. Once a velocity and distance (associated with a particular sample time) are determined, a signal can be generated for a higher-level system 524, such as an application layer or an operating system. As noted above, velocity and distance measurements can be used, in one example, for detection of raising a phone to, and withdrawing the phone from, a user's head.

The optical sensing system 500 can include other operational components as well. For example, in some embodiments, the optical sensing system 500 includes a waveform generator 526 that provides input to the digital-to-analog converter 508 driving the light emitter 506. The waveform generator 526 can define one or more operational modes for the light emitter 506, for example by applying a direct current pulse to the light emitter 506 (in a DC mode), or by applying a sawtooth waveform to estimate distance, and so on.

Output from the waveform generator 526 can also be informed by outputs from the receive side ADC, and/or a transmit-side photodetector, such as the photodetector 528. For example, if the photodetector 538 detects that light output from the light emitter 506 is shifting (e.g., due to temperature or other aggressor), the waveform generator 526 can adjust the waveform applied to the light emitter 506 to compensate.

These foregoing embodiments depicted in FIG. 5 and the various alternatives thereof and variations thereto are presented, generally, for purposes of explanation, and to facilitate an understanding of various configurations and constructions of a system, such as described herein. However, it will be apparent to one skilled in the art that some of the specific details presented herein may not be required in order to practice a particular described embodiment, or an equivalent thereof.

Thus, it is understood that the foregoing and following descriptions of specific embodiments are presented for the limited purposes of illustration and description. These descriptions are not targeted to be exhaustive or to limit the disclosure to the precise forms recited herein. To the contrary, it will be apparent to one of ordinary skill in the art that many modifications and variations are possible in view of the above teachings.

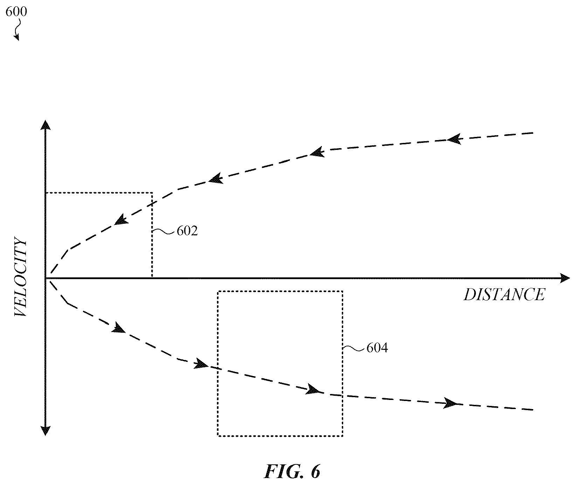

For example, generally and broadly, it may be appreciated that once a velocity and distance measurement or estimation are obtained by a system as described herein, higher-order analysis may be performed. For example, a "phone raise" or "phone lower" event can be detected based on combinations of velocities and distances. As one example, FIG. 6 shows an example relationship between velocity and distance that may be observed as a user raises a phone to the user's head and, thereafter lowers the phone. Such a pattern may present as a user accepts a phone call, and later finishes the phone call.

In this example, velocity and distance coordinates (pairs) can be tracked such that when a velocity/distance pair enters a particular region of the graph 600, a user "raise" event is signaled to an electronic device. In other words, a "phone raise" event may only be triggered if and only if both velocity and distance are within a region 602. Similarly, a "phase lower" event may only be triggered if and only if both velocity and distance are within region 604.

These foregoing embodiments depicted in FIG. 6 and the various alternatives thereof and variations thereto are presented, generally, for purposes of explanation, and to facilitate an understanding of various uses of a system configured to accurately and/or precisely detect both distance and velocity of an object nearby a display of an electronic device. However, it will be apparent to one skilled in the art that some of the specific details presented herein may not be required in order to practice a particular described embodiment, or an equivalent thereof.

Thus, it is understood that the foregoing and following descriptions of specific embodiments are presented for the limited purposes of illustration and description. These descriptions are not targeted to be exhaustive or to limit the disclosure to the precise forms recited herein. To the contrary, it will be apparent to one of ordinary skill in the art that many modifications and variations are possible in view of the above teachings.

For example, in some cases, an optical sensing system as described herein can be included into a button, a keyboard, a camera, an opaque (to visible light) surface, or any other suitable surface or input element in order to detect distance to and/or velocity of one or more objects nearby or within a field of view of the optical sensing system.

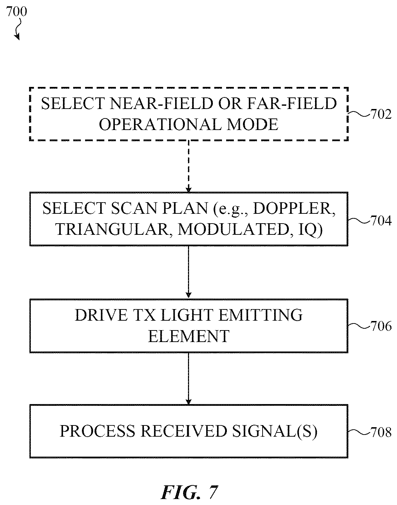

FIG. 7 is a flowchart depicting example operations of another method of operating an optical sensing system, such as described herein. The method 700 includes an optional operation 702 at which a near-field or far-field scanning mode are selected. In these examples, the selection can be made by an ASIC as described above. The near-field scanning mode can be used when determined distance is estimated to be below a particular threshold distance, whereas far-field scanning mode may be used when determined distance is estimated to be above a particular threshold distance.

The method 700 incudes operation 704 at which a scan plan is selected. Example scan plans include doppler scan plans (detecting changes in frequency and/or phase), triangular scan plans (monitoring beat frequencies to determine distance), modulated scan plans, IQ modulation scan plans, and so on.

The scan plan may be associated with a particular waveform or set of waveforms applied to a light emitter as described herein. Next, at operation 706, the light emitter can be driven according to the scan plan. Finally, at operation 708, received light (which may be merged with reference path light) may be analyzed.

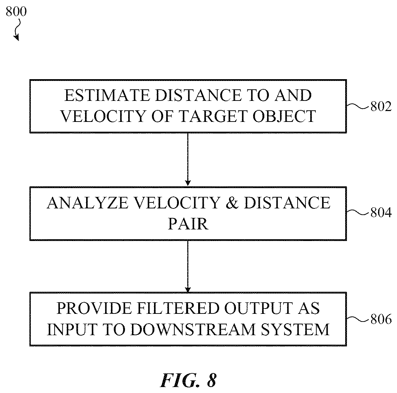

FIG. 8 is a flowchart depicting example operations of another method of operating an optical sensing system, such as described herein. the method 800 includes operation 802 at which a distance and a velocity are determined. For example, velocity can be measured by Doppler effect, and distance can be measured by modulated interferometry. At operation 804 velocity and distance can be analyzed as a pair, such a described above in reference to FIG. 6. Finally, at operation 806, a filtered output corresponding to a higher-order event (e.g., "phone raise" or "phone lower") can be communicated to another downstream system.

One may appreciate that, although many embodiments are disclosed above, the operations and steps presented with respect to methods and techniques described herein are meant as exemplary and accordingly are not exhaustive. One may further appreciate that alternate step order or fewer or additional operations may be required or desired for particular embodiments.

As used herein, the phrase "at least one of' preceding a series of items, with the term "and" or "or" to separate any of the items, modifies the list as a whole, rather than each member of the list. The phrase "at least one of" does not require selection of at least one of each item listed; rather, the phrase allows a meaning that includes at a minimum one of any of the items, and/or at a minimum one of any combination of the items, and/or at a minimum one of each of the items. By way of example, the phrases "at least one of A, B, and C" or "at least one of A, B, or C" each refer to only A, only B, or only C; any combination of A, B, and C; and/or one or more of each of A, B, and C. Similarly, it may be appreciated that an order of elements presented for a conjunctive or disjunctive list provided herein should not be construed as limiting the disclosure to only that order provided.

As used herein, the term "abutting" means that two elements share a common boundary or otherwise contact one another, while the term "adjacent" means that two elements are near one another and may (or may not) contact one another. Thus, elements that are abutting are also adjacent, although the reverse is not necessarily true. Two elements that are "coupled to" one another may be permanently or removably physically coupled to one another and/or operationally or functionally coupled to one another.

. Thus, the breadth and scope of the present invention should not be limited by any of the above-described exemplary embodiments but is instead defined by the claims herein presented. For example, any stationary or portable electronic device can include an optical sensing system, such as described herein. Example electronic devices include, but are not limited to: mobile phone devices; tablet devices; laptop devices; desktop computers; computing accessories; peripheral input devices; home or business networking devices; aerial, marine, submarine, or terrestrial vehicle control devices or networking devices; mobile entertainment devices; augmented reality devices; virtual reality devices; industrial control devices; digital wallet devices; home or business security devices; wearable devices; health or medical devices; implantable devices; clothing-embedded devices; fashion accessory devices; home or industrial appliances; media appliances; and so on.

## Claims

1. An electronic device (100, 200, 300) comprising:
a housing (102)
an optical sensing system (106, 202, 400) within the housing (102) for detecting proximity of an object external to the electronic device, the optical sensing system comprising:
a module housing (208) within the housing (102);
a light emitter (302) disposed within the module housing (208) and configured to emit light toward the object;
a light sensor array (312, 314) disposed within the module housing (208) and comprising at least two light sensors, each configured to receive light reflected from the object; and
an optical waveguide (214) disposed within the module housing (208) and optically coupling the light emitter and the light sensor array,
wherein the electronic device is a portable electronic device.

2. The electronic device of claim 1, wherein the light emitter comprises a laser.

3. The electronic device of claim 2, wherein the laser is an infrared laser.

4. The electronic device of claim 3, wherein the optical waveguide is formed from silicon.

5. The electronic device of claim 4, wherein the optical waveguide comprises at least one delay loop (420).

6. The electronic device of claim 5, wherein the optical waveguide comprises a directional coupler (414) optically coupling an input of the delay loop to an output of the light emitter.

7. The electronic device of claim 2, wherein the light sensor array comprises at least one infrared photodiode.

8. The electronic device of claim 1, comprising a display, wherein the optical sensing system is disposed such that the light emitter is configured to emit light through the display (204).

9. The electronic device of claim 8, wherein the light sensor array is configured to receive light reflected from the object that has passed through the display.

10. The electronic device of claim 1, wherein the optical waveguide comprises a beam splitter (304).

## Patentansprüche

1. Elektronische Vorrichtung (100, 200, 300), umfassend:
ein Gehäuse (102),
ein optisches Erfassungssystem (106, 202, 400) innerhalb des Gehäuses (102) zum Erkennen einer Nähe eines Objekts außerhalb der elektronischen Vorrichtung, wobei das optische Erfassungssystem umfasst:
ein Modulgehäuse (208) innerhalb des Gehäuses (102);
einen Lichtemitter (302), der innerhalb des Modulgehäuses (208) angeordnet und dazu eingerichtet ist, Licht auf das Objekt zu emittieren;
eine Lichtsensoranordnung (312, 314), die innerhalb des Modulgehäuses (208) angeordnet ist und mindestens zwei Lichtsensoren umfasst, die jeweils dazu eingerichtet sind, vom Objekt reflektiertes Licht zu empfangen; und
einen optischen Wellenleiter (214), der innerhalb des Modulgehäuses (208) angeordnet ist und den Lichtemitter und die Lichtsensoranordnung optisch koppelt, wobei die elektronische Vorrichtung eine tragbare elektronische Vorrichtung ist.

2. Elektronische Vorrichtung nach Anspruch 1, wobei der Lichtemitter einen Laser umfasst.

3. Elektronische Vorrichtung nach Anspruch 2, wobei der Laser ein Infrarotlaser ist.

4. Elektronische Vorrichtung nach Anspruch 3, wobei der optische Wellenleiter aus Silizium gebildet ist.

5. Elektronische Vorrichtung nach Anspruch 4, wobei der optische Wellenleiter mindestens eine Verzögerungsschleife (420) umfasst.

6. Elektronische Vorrichtung nach Anspruch 5, wobei der optische Wellenleiter einen Richtkoppler (414) umfasst, der einen Eingang der Verzögerungsschleife optisch mit einem Ausgang des Lichtemitters koppelt.

7. Elektronische Vorrichtung nach Anspruch 2, wobei die Lichtsensoranordnung mindestens eine Infrarotfotodiode umfasst.

8. Elektronische Vorrichtung nach Anspruch 1, umfassend eine Anzeige, wobei das optische Erfassungssystem so angeordnet ist, dass der Lichtemitter dazu eingerichtet ist, Licht durch die Anzeige (204) zu emittieren.

9. Elektronische Vorrichtung nach Anspruch 8, wobei die Lichtsensoranordnung dazu eingerichtet ist, vom Objekt reflektiertes Licht zu empfangen, das durch die Anzeige hindurchgegangen ist.

10. Elektronische Vorrichtung nach Anspruch 1, wobei der optische Wellenleiter einen Strahlteiler (304) umfasst.

## Revendications

1. Dispositif électronique (100, 200, 300) comprenant :
un boîtier (102)
un système de détection optique (106, 202, 400) à l'intérieur du boîtier (102) pour la détection d'une proximité d'un objet externe au dispositif électronique, le système de détection optique comprenant :
un boîtier de module (208) à l'intérieur du boîtier (102) ;
un émetteur de lumière (302) disposé à l'intérieur du boîtier de module (208) et configuré pour l'émission de lumière vers l'objet ;
un réseau de capteurs de lumière (312, 314) disposé à l'intérieur du boîtier de module (208) et comprenant au moins deux capteurs de lumière, chacun configuré pour la réception de lumière réfléchie à partir de l'objet ; et
un guide d'ondes optique (214) disposé à l'intérieur du boîtier de module (208) et couplant optiquement l'émetteur de lumière et le réseau de capteurs de lumière, dans lequel le dispositif électronique est un dispositif électronique portable.

2. Dispositif électronique selon la revendication 1, dans lequel l'émetteur de lumière comprend un laser.

3. Dispositif électronique selon la revendication 2, dans lequel le laser est un laser infrarouge.

4. Dispositif électronique selon la revendication 3, dans lequel le guide d'ondes optique est formé à partir de silicium.

5. Dispositif électronique selon la revendication 4, dans lequel le guide d'ondes optique comprend au moins une boucle à retard (420).

6. Dispositif électronique selon la revendication 5, dans lequel le guide d'ondes optique comprend un coupleur directionnel (414) couplant optiquement une entrée de la boucle à retard à une sortie de l'émetteur de lumière.

7. Dispositif électronique selon la revendication 2, dans lequel le réseau de capteurs de lumière comprend au moins une photodiode infrarouge.

8. Dispositif électronique selon la revendication 1, comprenant un affichage, dans lequel le système de détection optique est disposé de sorte que l'émetteur de lumière est configuré pour l'émission de lumière à travers l'affichage (204).

9. Dispositif électronique selon la revendication 8, dans lequel le réseau de capteurs de lumière est configuré pour la réception de lumière réfléchie à partir de l'objet qui a traversé l'affichage.

10. Dispositif électronique selon la revendication 1, dans lequel le guide d'ondes optique comprend un diviseur de faisceau (304).
